# EUROPEAN PATENT APPLICATION

(11) **EP 4 723 825 A2**
(43) Date of publication of application: **08.04.2026**
(21) Application number: 26156334.0
(22) Date of filing: 14.07.2023
(51) Int. Cl.: H10D 1/00, H10W 20/40, H01F 17/00, H10D 1/20

(54) **8-SHAPED INDUCTOR WITH GROUND BAR STRUCTURE**

(30) Priority: 28.07.2022 US 202263369666 P; 03.07.2023 US 202318218003
(62) Divisional of application: 23185523.0
(71) Applicant: MEDIATEK INC., Hsin-Chu 300 (TW)
(72) Inventor: HUNG, Hsin-Yu, 30078 Hsinchu City (TW); SUN, Ruey-Bo, 30078 Hsinchu City (TW); LIN, Sheng-Mou, 30078 Hsinchu City (TW)
(74) Representative: Hoefer & Partner Patentanwälte mbB

(57) **Abstract**

A semiconductor device (1a) includes a substrate (100); a first terminal (A) and a second terminal (B); and a conductor (210) arranged on the substrate (100) between the first terminal (A) and the second terminal (B) to constitute an inductor (IN) shaped for forming a first loop (L1) and a second loop (L2) arranged side-by-side along a first direction (D1). A crossing (C) of the conductor (210) with itself is present between the first loop (L1) and the second loop (L2). The first loop (L1) and the second loop (L2) define a first enclosed area (A1) and a second enclosed area (A2), respectively. A first ground bar (GB1) traverses the first loop (L1) and a second ground bar (GB2) traverses the second loop (L2).

## Description

### Cross Reference to Related Applications

This application claims the benefit of U.S. Provisional Application No. 63/369,666, filed on July 28th, 2022. The content of the application is incorporated herein by reference.

### Background

This invention relates to integrated circuit inductors, and more particularly to an on-die, 8-shaped inductor with ground bar structure capable for mitigating inductor coupling.

Inductance-capacitance phase-locked loop (LC-PLL) circuits are used in both wireless and wireline communication systems, as well as other applications and environments. The integrated inductor of the LC tank in a voltage-controlled oscillator (VOC) plays a key role for the overall circuit performance, especially affecting phase noise significantly.

It is known that insufficient isolation between different inductors of LC-PLL circuits may degrade the phase noise suppression performance of an oscillator in a silicon die due to inductor coupling effects. There is a need in this technical field to reduce the inductor coupling between inductors on a silicon die.

### Summary

It is one object of the present disclosure to provide an improved integrated inductor for mitigating inductor noise coupling and a device using the same. A semiconductor device according to the invention is defined in independent claim 1. The dependent claims define preferred embodiments thereof.

One aspect of the invention provides a semiconductor device including a substrate; a first terminal and a second terminal; a conductor arranged on the substrate between the first terminal and the second terminal to constitute an inductor shaped for forming a first loop and a second loop arranged side-by-side along a first direction, wherein a crossing of the conductor with itself is present between the first loop and the second loop, wherein the first loop and the second loop define a first enclosed area and a second enclosed area, respectively; and at least one ground bar traversing either the first loop or the second loop.

Preferably, the inductor is at least partially surrounded by a ground ring.

Preferably, the ground ring is constructed at a top metal layer over the substrate.

Preferably, the at least one ground bar is electrically connected to the ground ring.

Preferably, the at least one ground bar passes through a center of either the first loop or the second loop.

Preferably, the at least one ground bar extends along a second direction that is orthogonal to the first direction.

Preferably, the at least one ground bar is fabricated with a minimum design rule.

Preferably, the at least one ground bar has a line width substantially smaller than or equal to loop size of the first loop or the second loop.

Preferably, the at least one ground bar is not electrically connected to the conductor.

Preferably, the first enclosed area is smaller than the second enclosed area.

Another aspect of the invention provides a semiconductor device including a substrate; a first terminal and a second terminal; a conductor arranged on the substrate between the first terminal and the second terminal to constitute an inductor shaped for forming a first loop and a second loop arranged side-by-side along a first direction, wherein a crossing of the conductor with itself is present between the first loop and the second loop, wherein the first loop and the second loop define a first enclosed area and a second enclosed area, respectively; a first ground bar traversing the first loop; and a second ground bar traversing the second loop.

Preferably, the inductor is at least partially surrounded by a ground ring.

Preferably, the ground ring is constructed at a top metal layer over the substrate.

Preferably, the first ground bar and the second ground bar are electrically connected to the ground ring.

Preferably, the first ground bar passes through a center of the first loop and the second ground bar passes through a center of the second loop.

Preferably, the first ground bar and the second ground bar extend along a second direction that is orthogonal to the first direction.

Preferably, the first ground bar and the second ground bar are fabricated with a minimum design rule.

Preferably, the first ground bar and the second ground bar are not electrically connected to the conductor.

Preferably, the semiconductor device further includes a third ground bar interposed between the first ground bar and the second ground bar.

Preferably, the third ground bar overlaps with the crossing.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 shows an exemplary semiconductor device in accordance with an embodiment of the invention;
FIG. 2 is a schematic diagram showing a semiconductor device according to another embodiment of the invention;
FIG. 3 is a schematic diagram showing a semiconductor device according to still another embodiment of the invention; and
FIG. 4 is an experimental plot showing the isolation enhancement of the semiconductor device.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

As the integration surface on silicon is getting smaller and smaller, interactions among sensitive blocks and electromagnetic (EM) sources (like voltage controlled oscillators or VOCs) become stronger. The voltage controlled oscillator performance governs many aspects of the performance of the whole phase locked loop or frequency synthesizer. An inductor-capacitor voltage-controlled oscillator (LC-VOC) is comprised of a negative gm cell, a switched capacitor array (SCA), an inductor, and so on. 8-shaped inductors are used in the inductor-capacitor voltage-controlled oscillator.

However, the noise coupling has become an issue for such 8-shaped inductor. Insufficient isolation between inductors in LC-PLL circuits may degrade the phase noise suppression performance of an oscillator in a silicon die due to inductor coupling effects.

The present disclosure provides a semiconductor device comprising an 8-shaped inductor for on-die inductor coupling mitigation in order to address this problem. A better electrical performance can be obtained in a case that the inductor according to the present disclosure is used in, for example a voltage-controlled oscillator. According to the experimental results, at least 15dB coupled noise reduction can be observed at the inductor of a victim circuit.

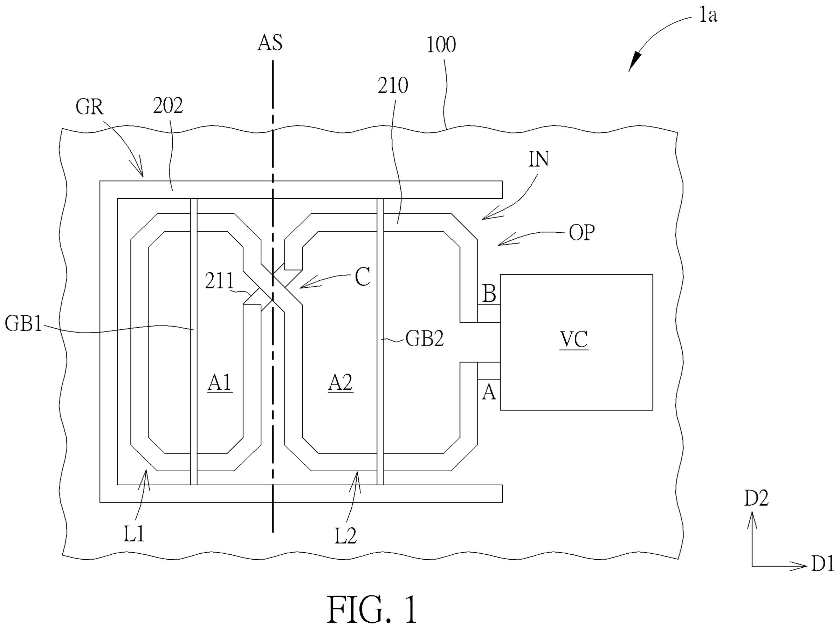

FIG. 1 shows a semiconductor device 1a in accordance with an embodiment of the invention. As shown in FIG. 1, a semiconductor device 1a comprises a substrate 100 such as a silicon-based substrate and an inductor IN fabricated on the substrate 100. Preferably, the inductor IN is at least partially surrounded by a ground ring GR. Preferably, for example, the ground ring GR may be constructed at top metal layers 202 over the substrate 100. The top metal layer mentioned herein is not limited to the topmost metal layer. For example, the top metal layers may comprise the topmost metal layer and several upper metal layers below the topmost metal layer. It is to be understood that the ground ring GR may be defined in any of the top metal layers.

Preferably, for example, the top metal layer 202 may be an aluminum layer, but is not limited thereto. The inductor IN is formed by using a conductor 210 that is arranged between two terminals A, B of a circuit VC, for example, a victim circuit that is disposed adjacent to an opened end OP of the ground ring GR. Although an open-loop type ground ring GR is illustrated, it is to be understood that in some embodiments the ground ring GR may be a close-loop type ground ring. Preferably, for example, the circuit VC may be a switched capacitor array of an inductor-capacitor voltage-controlled oscillator, but is not limited thereto.

Preferably, the conductor 210 is shaped for forming a first loop L1 and a second loop L2 of the single-turn inductor IN. The first loop L1 and the second loop L2 are arranged side-by-side along a first direction D1. A crossing C is present between the first loop L1 and the second loop L2. When viewed from the above, the first loop L1 encloses a first area A1 and the second loop L2 encloses a second area A2. The first loop L1 is defined by the conductor 210 and the crossing C, which makes the first area A1, at least in projection in a direction perpendicular to the plane in which the first loop is arranged, fully enclosed. The second loop L2 is defined by the conductor 210 and the crossing C. Preferably, the second area A2 is not fully enclosed.

Preferably, the first loop L1 may be asymmetric to the second loop L2 with respect to the axis AS, and the first area A1 may be smaller than the second area A2. In this case, the second loop L2 with larger surface area is disposed closer to the circuit VC and the first loop L1 is disposed farther away from the circuit VC. Preferably, the first loop L1 may be symmetric to the second loop L2 with respect to the axis AS. It is not intended to limit the size of the two loops. In some embodiments, the first loop L1 may be greater than the second loop L2, depending on the design requirements of the figure-eight inductor.

The inductor IN may be fabricated on the substrate 100 by conventional semiconductor fabrication processes including but not limited to deposition, lithography, etching, cleaning, polishing, annealing or the like. The inductor IN may be composed of at least two interconnect layers. Generally, the thicker top interconnect layer has lower resistance and the inductor IN is generally laid out in the top metal layers, except for the locations where the conductor 210 crosses itself. At those crossings the lower interconnect layer may be used. For example, in FIG. 1, the conductor 210 may be located in the top metal layers and connected to an underlying interconnect layer 211 at the crossing C. The interconnect layer 211 may be located in the lower metal layer.

Preferably, the inductor IN further comprises a first ground bar GB1 traversing the first loop L1 and a second ground bar GB2 traversing the second loop L2. Preferably, the first ground bar GB1 and the second ground bar GB2 may extend along a second direction D2. Preferably, the second direction D2 may be orthogonal to the first direction D1. Preferably, for example, the first ground bar GB1 may pass through the center of the first loop L1 and the second ground bar GB2 may pass through the center of the second loop L2. Optionally, one of the first ground bar GB1 and the second ground bar GB2 may be omitted. The inductor IN may comprise at least one ground bar passing through a center of either of the first loop L1 or the second loop L2.

Preferably, for example, the first ground bar GB1 and the second ground bar GB2 may be fabricated with a minimum design rule or may have a width or dimension that substantially equals to the minimum line width of metal interconnection layer or the interconnection process limits, which may vary with different processes. In some embodiments, the first ground bar GB1 and the second ground bar GB2 may have various widths, but not limited to the minimum design rule, as long as their sizes do not exceed the loop size. The width or dimension of the first ground bar GB1 and the second ground bar GB2 is a tradeoff between inductor performance and inductor-inductor spur level. Preferably, the first ground bar GB1 and the second ground bar GB2 are electrically connected to the ground ring GR. The first ground bar GB1 and the second ground bar GB2 are not electrically connected to the conductor 210 or the interconnect layer 211. The first ground bar GB1 and the second ground bar GB2 may be fabricated at a metal layer that is different from the conductor 210. According to an exemplary embodiment, as shown in FIG. 1, the first ground bar GB1 and the second ground bar GB2 are disposed at a metal layer that is higher than the conductor 210. However, it is to be understood that the first ground bar GB1 and the second ground bar GB2 may be fabricated at a metal layer that is lower than the conductor 210 in some cases. In operation, the first ground bar GB1 and the second ground bar GB2 are grounded, which can effectively reduce the inductor coupling effect.

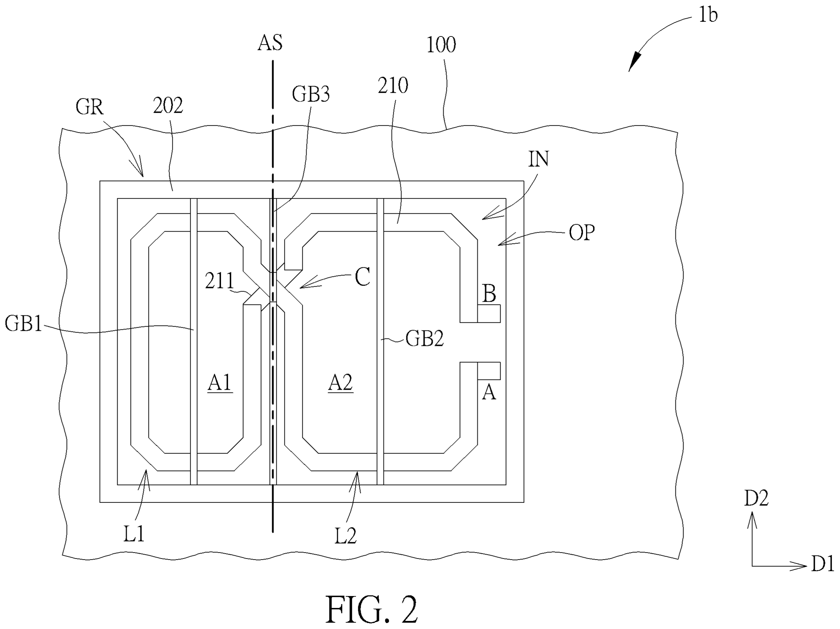

FIG. 2 is a schematic diagram showing a semiconductor device 1b according to another embodiment of the invention, wherein like regions, layers or elements are designated by like numeral numbers or labels. As shown in FIG. 2, the inductor IN of the semiconductor device 1b may further comprise a third ground bar GB3 interposed between the first ground bar GB1 and the second ground bar GB2. When viewed from the above, the third ground bar GB3 may overlap with the crossing C. Preferably, the third ground bar GB3 may pass through the center of the inductor IN. Preferably, the third ground bar GB3 may extend along the second direction D2 and in parallel with the first ground bar GB1 and the second ground bar GB2.

Likewise, the third ground bar GB3 may be fabricated with a minimum design rule or may have a width or dimension that substantially equals to the minimum line width of metal interconnection layer or the interconnection process limits, which may vary with different processes. Preferably, the third ground bar GB3 is also electrically connected to the ground ring GR. The third ground bar GB3 is not electrically connected to the conductor 210 or the interconnect layer 211. The third ground bar GB3 is fabricated at a metal layer that is different from the conductor 210 or the interconnect layer 211. Preferably, the first ground bar GB1, the second ground bar GB2, and the third ground bar GB3 may be fabricated at the same metal layer.

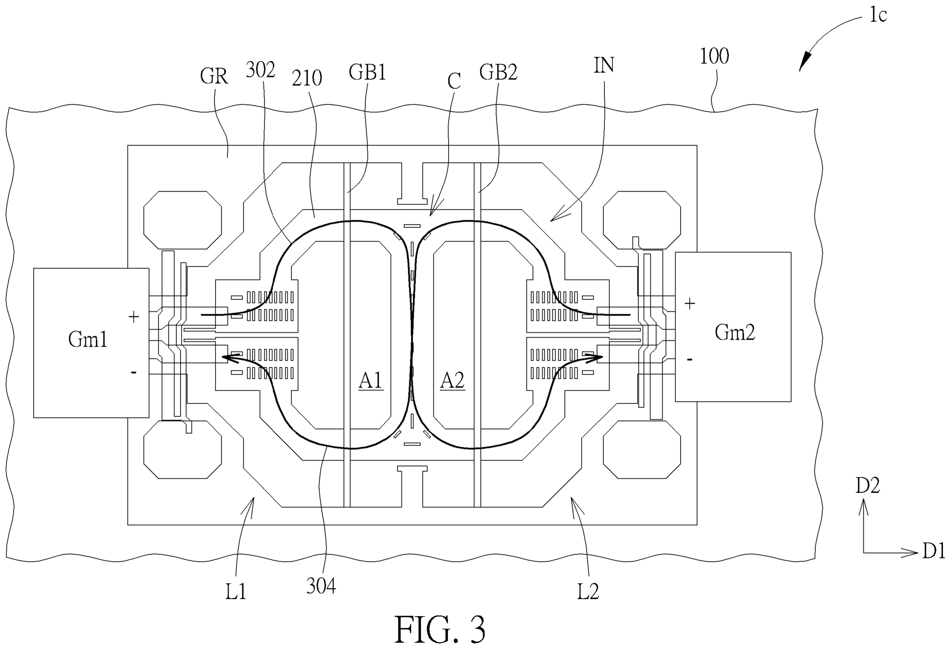

FIG. 3 is a schematic diagram showing a semiconductor device 1c according to still another embodiment of the invention, wherein like regions, layers or elements are designated by like numeral numbers or labels. The semiconductor device 1c may be a dual core oscillator. As shown in FIG. 3, the semiconductor device 1c comprises a substrate 100 such as a silicon-based substrate and an inductor IN fabricated on the substrate 100. Preferably, the inductor IN is at least partially surrounded by a ground ring GR. Preferably, for example, the ground ring GR may be constructed at top metal layers 202 over the substrate 100. The inductor IN is formed by using a conductor 210 that is arranged between terminals of circuits such as gm cells Gm1 and Gm2. The 8-shaped current flow of the semiconductor device 1c is indicated by arrows 302 and 304. The current 302 flows from the positive terminal of the gm cell Gm1 to the negative terminal of the gm cell Gm2. The current 302 flows from the positive terminal of the gm cell Gm2 to the negative terminal of the gm cell Gm1.

Preferably, the conductor 210 is shaped for forming a first loop L1 and a second loop L2 of the single-turn inductor IN. The first loop L1 and the second loop L2 are arranged side-by-side along a first direction D1. A crossing C is present between the first loop L1 and the second loop L2. When viewed from the above, the first loop L1 encloses a first area A1 and the second loop L2 encloses a second area A2.

Preferably, the inductor IN further comprises a first ground bar GB1 traversing the first loop L1 and a second ground bar GB2 traversing the second loop L2. Preferably, the first ground bar GB1 and the second ground bar GB2 may extend along a second direction D2. Preferably, the second direction D2 may be orthogonal to the first direction D1. Preferably, for example, the first ground bar GB1 may pass through the center of the first loop L1 and the second ground bar GB2 may pass through the center of the second loop L2. Optionally, one of the first ground bar GB1 and the second ground bar GB2 may be omitted.

Preferably, the first ground bar GB1 and the second ground bar GB2 may be fabricated with a minimum design rule or may have a width or dimension that substantially equals to the minimum line width of metal interconnection layer or the interconnection process limits, which may vary with different processes. Preferably, the first ground bar GB1 and the second ground bar GB2 are electrically connected to the ground ring GR. The first ground bar GB1 and the second ground bar GB2 are not electrically connected to the conductor 210. The first ground bar GB1 and the second ground bar GB2 may be fabricated at a metal layer that is different from the conductor 210.

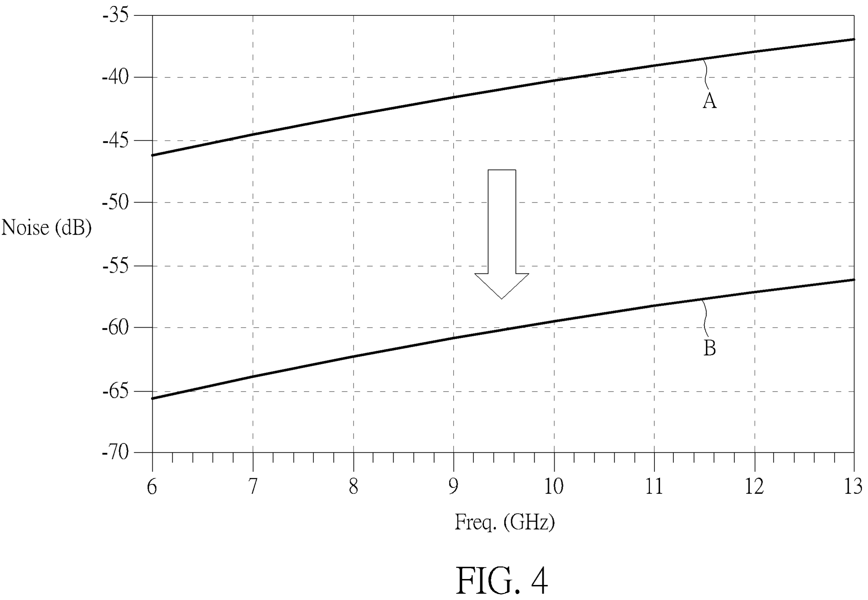

In operation, the first ground bar GB1 and the second ground bar GB2 are grounded, which can effectively reduce the inductor coupling effect. FIG. 4 is an experimental plot showing the isolation enhancement of the semiconductor device. In FIG. 4, curve A represents the noise versus frequency trend of inductor coupling based on prior art design and curve B represents the noise versus frequency trend of inductor coupling based on the present invention. As shown in FIG. 4, over 15dB coupled noise reduction can be achieved.

Those skilled in the art will readily observe that numerous modifications and alterations of the device and method may be made while retaining the teachings of the invention. Accordingly, the above disclosure should be construed as limited only by the metes and bounds of the appended claims.
The present invention can also be described by means of the following clauses:
1. A semiconductor device (1a; 1b; 1c), comprising:
   a substrate (100);
   a first terminal (A) and a second terminal (B);
   a conductor (210) arranged on the substrate (100) between the first terminal (A) and the second terminal (B) to constitute an inductor (IN) shaped for forming a first loop (L1) and a second loop (L2) arranged side-by-side along a first direction (D1), wherein a crossing (C) of the conductor (210) with itself is present between the first loop (L1) and the second loop (L2), wherein the first loop (L1) and the second loop (L2) define a first enclosed area (A1) and a second enclosed area (A2), respectively; and
   at least one ground bar (GB1, GB2) traversing either the first loop (L1) or the second loop (L2).
2. The semiconductor device (1a; 1b; 1c) according to clause 1, wherein the at least one ground bar (GB1, GB2) traversing either the first loop (L1) or the second loop (L2) comprises a first ground bar (GB1) traversing the first loop (L1) and a second ground bar (GB2) traversing the second loop (L2).
3. The semiconductor device (1a; 1b; 1c) according to clause 1 or 2, wherein the inductor (IN) is at least partially surrounded by a ground ring (GR).
4. The semiconductor device (1a; 1b; 1c) according to clause 3, wherein the ground ring (GR) is constructed at a top metal layer (202) over the substrate (100).
5. The semiconductor device (1a; 1b; 1c) according to clause 3 or 4, wherein the at least one ground bar (GB1, GB2) traversing either the first loop (L1) or the second loop (L2) is electrically connected to the ground ring;
   wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) and the second ground bar (GB2) are electrically connected to the ground ring (GR).
6. The semiconductor device (1a; 1b; 1c) according to any one of clauses 1 to 5, wherein the at least one ground bar (GB1, GB2) traversing either the first loop (L1) or the second loop (L2) passes through a center of either the first loop (L1) or the second loop (L2);
   wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) passes through a center of the first loop (L1) and the second ground bar (GB2) passes through a center of the second loop (L2).
7. The semiconductor device (1a; 1b; 1c) according to any one of clauses 1 to 6, wherein the at least one ground bar (GB1, GB2) traversing either the first loop (L1) or the second loop (L2) extends along a second direction (D2) that is orthogonal to the first direction (D1);
   wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) and the second ground bar (GB2) extend along a second direction (D2) that is orthogonal to the first direction (D1).
8. The semiconductor device (1a; 1b; 1c) according to any one of clauses 1 to 7, wherein the at least one ground bar (GB1, GB2) traversing either the first loop (L1) or the second loop (L2) is fabricated with a minimum design rule;
   wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) and the second ground bar (GB2) are fabricated with a minimum design rule.
9. The semiconductor device (1a; 1b; 1c) according to any one of clauses 1 to 8, wherein the at least one ground bar (GB1, GB2) traversing either the first loop (L1) or the second loop (L2) has a line width substantially smaller than or equal to loop size of the first loop (L1) or the second loop (L2);
   wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) has a line width substantially smaller than or equal to loop size of the first loop (L1) and the second ground bar (GB2) has a line width substantially smaller than or equal to loop size of the second loop (L2).
10. The semiconductor device (1a; 1b; 1c) according to any one of clauses 1 to 9, wherein the at least one ground bar (GB1, GB2) traversing either the first loop (L1) or the second loop (L2) is not electrically connected to the conductor (210);
   wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the first ground bar (GB1) and the second ground bar (GB2) are not electrically connected to the conductor (210).
11. The semiconductor device (1a; 1b; 1c) according to any one of clauses 1 to 10, wherein the first enclosed area (A1) is smaller than the second enclosed area (A2).
12. The semiconductor device (1b) according to any one of clauses 1 to 11 further comprising:
   at least one ground bar (GB3) not traversing the first loop (L1) and the second loop (L2); wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the at least one ground bar (GB3) not traversing the first loop (L1) and the second loop (L2) comprises a third ground bar (GB3) interposed between the first ground bar (GB1) and the second ground bar (GB2).
13. The semiconductor device (1b) according to clause 12, wherein the at least one ground bar (GB3) not traversing the first loop (L1) and the second loop (L2) overlaps with the crossing (C);
   wherein for the case that the at least one ground bar (GB1, GB2) traversing either the first loop (L1) or the second loop (L2) comprises the first ground bar (GB1) traversing the first loop (L1) and the second ground bar (GB2) traversing the second loop (L2), the third ground bar (GB3) overlaps with the crossing (C).

## Claims

1. A semiconductor device (1a; 1b; 1c), comprising:
a substrate (100);
a first terminal (A) and a second terminal (B);
a conductor (210) arranged on the substrate (100) between the first terminal (A) and the second terminal (B) to constitute an inductor (IN) shaped for forming a first loop (L1) and a second loop (L2) arranged side-by-side along a first direction (D1), wherein a crossing (C) of the conductor (210) with itself is present between the first loop (L1) and the second loop (L2), wherein the first loop (L1) and the second loop (L2) define a first enclosed area (A1) and a second enclosed area (A2), respectively;
**characterized by**:
a first ground bar (GB1) traversing the first loop (L1); and
a second ground bar (GB2) traversing the second loop (L2).

2. The semiconductor device (1a; 1b; 1c) according to claim 1, wherein the inductor (IN) is at least partially surrounded by a ground ring (GR).

3. The semiconductor device (1a; 1b; 1c) according to claim 2, wherein the ground ring (GR) is constructed at a top metal layer (202) over the substrate (100).

4. The semiconductor device (1a; 1b; 1c) according to claim 2 or 3, wherein the first ground bar (GB1) and the second ground bar (GB2) are electrically connected to the ground ring (GR).

5. The semiconductor device (1a; 1b; 1c) according to any one of claims 1 to 4, wherein the first ground bar (GB1) passes through a center of the first loop (L1) and the second ground bar (GB2) passes through a center of the second loop (L2).

6. The semiconductor device (1a; 1b; 1c) according to any one of claims 1 to 5, wherein the first ground bar (GB1) and the second ground bar (GB2) extend along a second direction (D2) that is orthogonal to the first direction (D1).

7. The semiconductor device (1a; 1b; 1c) according to any one of claims 1 to 6, wherein the first ground bar (GB1) and the second ground bar (GB2) are fabricated with a minimum design rule.

8. The semiconductor device (1a; 1b; 1c) according to any one of claims 1 to 7, wherein the first ground bar (GB1) and the second ground bar (GB2) are not electrically connected to the conductor (210).

9. The semiconductor device (1b) according to any one of claims 1 to 8 further comprising:
a third ground bar (GB3) interposed between the first ground bar (GB1) and the second ground bar (GB2).

10. The semiconductor device (1b) according to claim 9, wherein the third ground bar (GB2) overlaps with the crossing (C).
